# DEMANDE DE BREVET EUROPEEN

(11) **EP 1 791 140 A1**
(43) Date de publication de la demande: **30.05.2007**
(21) Numéro de dépôt: 06380182.3
(22) Date de dépôt: 29.06.2006
(51) Int. Cl.: H01F 21/12

(54) **Filtre passe-bande**

(30) Priorité: 25.11.2005 ES 200502921
(71) Demandeur: Angel Iglesias S.A., 20009 San Sebastian (ES)
(72) Inventeur: Campo Pablos, Miguel Angel, 20009 San Sebastian (Gipuzkoa) (ES); San José Damboriena, Jesús María, 20009 San Sebastian (Gipuzkoa) (ES)
(74) Mandataire: Urizar Barandiaran, Miguel Angel

(57) **Abrégé**

Filtre passe-bande, de ceux qui comprennent une inductance et une capacitance, se caractérisant par le fait qu'il présente une inductance variable, qui se compose d'une bobine hélicoïdale (1), d'un élément mobile (4) en contact avec la masse, ayant un déplacement à l'intérieur ou à l'extérieur de la bobine hélicoïdale (1), court-circuitant plus ou moins de spires de la bobine, en fonction de ce déplacement, de sorte que l'inductance varie avec le déplacement, et d'une capacitance fixe.

## Description

L'objet de l'invention est un filtre passe-bande avec son système d'ajustement dans une cavité grâce à la variation de l'inductance.

Dans l'état actuel de la technique, tous les filtres connus qui se composent d'une inductance et d'une capacitance et qui ont pour base des cavités, s'ajustent à la fréquence voulue en faisant varier la capacitance du circuit LC, l'inductance étant laissée fixe. Dans le filtre qui fait l'objet de l'invention, nous laissons la capacitance fixe et nous agissons sur l'inductance, en la faisant varier jusqu'à l'obtention de la fréquence de résonance voulue.

Le filtre pour amplificateur qui fait l'objet de l'invention étant de ceux qui se composent d'une inductance et d'une capacitance, se caractérise par le fait que :
a) il présente une inductance variable et une capacitance fixe ;
b) l'inductance comprend une bobine hélicoïdale et un élément mobile en contact avec la masse, avec un déplacement à l'intérieur ou à l'extérieur de la bobine hélicoïdale court-circuitant plus ou moins de spires de la bobine en fonction de ce déplacement, de sorte que l'inductance varie avec ce déplacement ;
c) l'élément mobile et la bobine hélicoïdale se comportent mécaniquement comme un écrou et une vis, ou vice versa ;
d) la masse avec laquelle entre en contact la pièce mobile est le châssis; l'élément mobile se déplace linéairement, guidé par une tige fixe, qui émerge du propre châssis ;
e) l'élément mobile définit, à son extrémité, au moins une broche constamment guidée entre les spires de la bobine hélicoïdale.

Alternativement, l'inductance variable peut être obtenue, par exemple, en disposant à l'intérieur de la bobine, un noyau déplaçable, de sorte que l'inductance varie quand le noyau fait varier la perméabilité.

La capacitance fixe est obtenue en intégrant le condensateur dans le propre châssis : avec la cosse de la bobine insérée dans un manchon diélectrique qui s'encastre, à son tour, sur une languette métallique du châssis lui-même.

Pour mieux comprendre l'objet de la présente invention, on représente sur les plans une forme préférentielle de réalisation pratique, susceptible de changements accessoires qui n'en dénaturent pas le fondement.

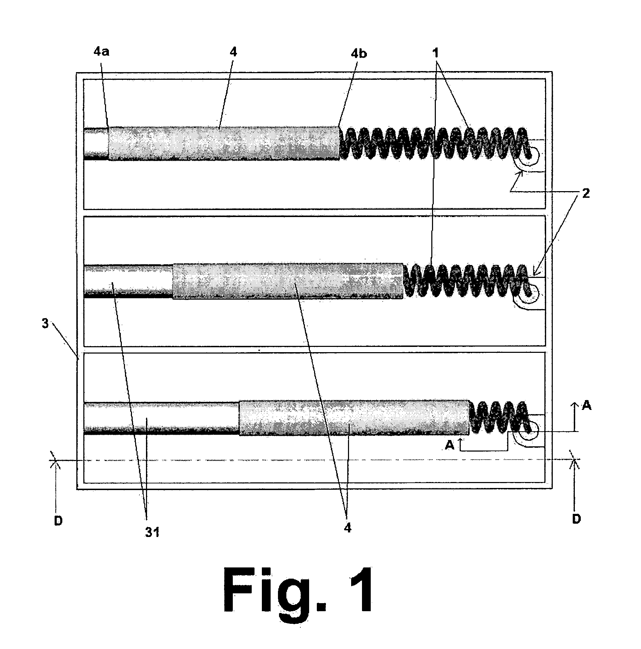

La figure 1 représente une vue générale en plan d'un filtre pour amplificateur, selon l'invention.

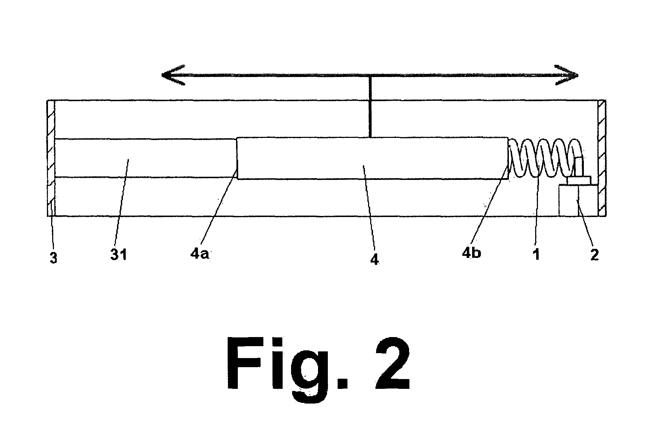

La figure 2 représente une section générale de profil en long, selon l'indication D:D de la figure 1.

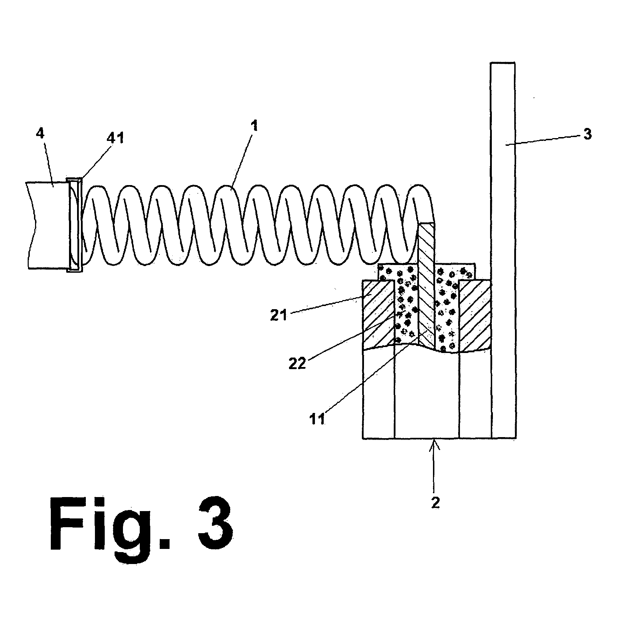

La figure 3 représente une section au détail augmenté, selon l'indication A:A de la figure 1.

On décrit ci-dessous un exemple de réalisation pratique, non limitative, de la présente invention.

L'objet de l'invention est un filtre pour amplificateur, de ceux qui comportent une inductance et une capacitance, composé de :
- un châssis (3)
- une bobine (1)
- un condensateur (2), et
- un élément mobile (4).

Conformément à l'invention, la bobine (1) est à inductance variable et le condensateur (2) est à capacitance fixe.

Selon la réalisation représentée, l'inductance variable est obtenue en employant une bobine hélicoïdale (1) associée au condensateur à capacitance fixe (2) et en disposant l'élément mobile (4) en contact permanent avec elle et avec la masse, de sorte que l'inductance varie quand l'élément mobile (4) se déplace pour court-circuiter plus ou moins de spires de la bobine hélicoïdale (1).

Comme inductance, on utilise une pièce hélicoïdale (1) qui se comporte comme une bobine. En réduisant ou en augmentant peu à peu les spires au moyen d'un ajustement mécanique, on réduit ou on augmente l'inductance, ce qui, en définitive, permet de faire varier la fréquence de résonance du filtre.

L'élément mobile (4) et la bobine hélicoïdale (1) se comportent mécaniquement comme un jeu de vis/écrou.

Cette augmentation ou cette réduction des spires s'effectue avec l'élément mobile (4), qui est une pièce cylindrique ayant, au moins, une broche (41) à l'intérieur, qui étreint la bobine hélicoïdale (1). Cet élément (4) est mobile axialement, guidé sur une tige fixe (31), qui émerge du propre châssis (3). La direction de la course est coaxiale par rapport à la pièce hélicoïdale (1). L (1). L'une de ses extrémités (4a) est toujours en contact avec le châssis (3) faisant masse par l'intermédiaire de la tige fixe (31). L'autre extrémité (4b) est en contact avec la pièce hélicoïdale (1) par l'intermédiaire de la broche (41), ce qui fait qu'il y a, à tout moment, un contact électrique entre la pièce hélicoïdale (1) et le châssis (3).

À son tour, la pièce hélicoïdale (1) est assemblée, à l'autre extrémité, à un condensateur qui a une capacitance fixe (2) et celle-ci au châssis (3) qui a un circuit LC résonant. La fréquence de résonance dépendra de la valeur de L et de C. Comme C est fixe, nous contrôlerons la valeur de la fréquence de résonance en faisant varier L, en appliquant la méthode qui consiste à réduire des spires sur la pièce hélicoïdale (1).

Sont comprises dans l'objet de l'invention toutes les réalisations alternatives quelles qu'elles soient qui n'altèrent, ne changent ou ne modifie pas le caractère essentiel proposé, tel que, par exemple et en particulier, l'obtention de l'inductance variable en disposant, à l'intérieur de la bobine, un noyau déplaçable de telle sorte que l'inductance varie quand le noyau fait varier la perméabilité.

Pour sa part, dans la réalisation représentée, le condensateur à capacitance fixe (2) est obtenu :
- en façonnant sur le propre châssis (3) une languette métallique (21),
- en insérant un manchon diélectrique (22) emboîté sur cette languette métallique (21), et
- en disposant la cosse (11) de la bobine (1) insérée dans ce manchon diélectrique (22).

## Revendications

1. Filtre passe-bande, de ceux qui se composent d'une inductance et d'une capacitance, **se caractérisant par le fait qu'**il présente une inductance variable et uen capacitance fixe.

2. Filtre passe-bande, selon la revendication antérieure, **se caractérisant par le fait que** l'inductance se compose d'une bobine hélicoïdale (1) et d'un élément mobile (4) en contact avec la masse, ayant un déplacement à l'intérieur ou l'extérieur de la bobine hélicoïdale (1), court-circuitant plus ou moins de spires de la bobine, en fonction de ce déplacement, de sorte que l'inductance varie avec ce déplacement.

3. Filtre passe-bande, selon la revendication 1, **se caractérisant par le fait que** l'élément mobile (4) et la bobine hélicoïdale (1) se comportent mécaniquement comme un écrou et une vis ou vice versa.

4. Filtre passe-bande, selon les revendications antérieures, **se caractérisant par le fait que** la pièce mobile (4) entre en contact avec le châssis (3).

5. Filtre passe-bande, selon les revendications antérieures, **se caractérisant par le fait que** l'élément mobile (4) se déplace linéairement guidé sur une tige fixe (31) qui émerge du propre châssis (3).

6. Filtre passe-bande, selon les revendications antérieures, **se caractérisant par le fait que** l'élément mobile (4) définit, à son extrémité, au moins une broche (41) constamment guidée entre les spires de la bobine hélicoïdale (1).

7. Filtre passe-bande, selon les revendications 1 et 2, **se caractérisant par le fait que** l'inductance variable est obtenue en disposant, à l'intérieur de la bobine, un noyau déplaçable, de sorte que l'inductance varie, lorsque le noyau fait varier la perméabilité.

8. Filtre passe-bande, selon les revendications antérieures, **se caractérisant par le fait que** la capacitance fixe est obtenue en intégrant le condensateur (2) dans le propre châssis (3); avec la cosse (11) de la bobine (1) insérée dans un manchon diélectrique (22) encastré, à son tour, sur une languette métallique (21) du propre châssis (3).
